(19) Europäisches Patentamt
European Patent Office
Office européen des brevets

(11) **EP 3 840 016 A1**

(12) **DEMANDE DE BREVET EUROPEEN**

(43) Date de publication:
**23.06.2021 Bulletin 2021/25**

(21) Numéro de dépôt: **20214254.3**

(22) Date de dépôt: **15.12.2020**

(51) Int Cl.:
*H01L 21/02* (2006.01)   *H01L 21/306* (2006.01)
*H01L 33/00* (2010.01)   *H01L 33/12* (2010.01)
*H01L 33/32* (2010.01)

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME
KH MA MD TN**

(30) Priorité: **19.12.2019   FR 1914960**

(71) Demandeur: **Commissariat à l'énergie atomique
et aux énergies alternatives
75015 Paris (FR)**

(72) Inventeurs:
• **PERNEL, Carole**
  **38054 GRENOBLE Cedex 09 (FR)**
• **DUSSAIGNE, Amélie**
  **38054 GRENOBLE Cedex 09 (FR)**

(74) Mandataire: **Brevalex
95, rue d'Amsterdam
75378 Paris Cedex 8 (FR)**

(54) **PROCEDE POUR FABRIQUER UN SUBSTRAT COMPRENANT UNE COUCHE D'INGAN RELAXEE**

(57)   Procédé pour fabriquer un substrat comprenant les étapes suivantes :
- fournir un empilement comprenant un substrat initial, une couche de GaN, une couche d'InGaN dopée (13) et une couche d'InGaN non intentionnellement dopée (14),
- reporter la couche d'InGaN dopée (13) et la couche d'InGaN non intentionnellement dopée (14) sur un support d'anodisation (21), de manière à former un deuxième empilement (20),
- plonger le deuxième empilement (20) et la contre-électrode dans une solution électrolytique, et appliquer une tension ou un courant entre la couche d'InGaN dopée (13) et une contre-électrode, pour porosifier la couche d'InGaN dopée (13), et relaxer la couche d'InGaN non intentionnellement dopée (14),
- reporter la couche d'InGaN dopée (13) et la couche d'InGaN non intentionnellement dopée (14) sur un support d'intérêt,
- former une couche d'InGaN par épitaxie sur la couche d'InGaN non intentionnellement dopée, moyennant quoi on obtient une couche d'InGaN épitaxiée relaxée.

FIG.1B

EP 3 840 016 A1

## Description

## DOMAINE TECHNIQUE

La présente invention se rapporte au domaine général des micro-écrans couleur.

L'invention concerne un procédé pour fabriquer un substrat ou un pseudo-substrat comprenant une couche d'InGaN relaxée.

L'invention concerne également un substrat ou un pseudo-substrat comprenant une couche d'InGaN relaxée.

L'invention trouve des applications dans de nombreux domaines industriels, et notamment dans le domaine des micro-écrans couleur à base de micro-LEDs au pas inférieur à 10 μm.

## ÉTAT DE LA TECHNIQUE ANTÉRIEURE

Les micro-écrans couleurs comprennent des pixels bleus, verts et rouges (pixels RGB).

Les pixels bleus et verts peuvent être fabriqués à base de matériaux nitrures et les pixels rouges à base de matériaux phosphores. Pour combiner sur le même substrat ces trois types de pixels, la technique dite de « pick and place » est généralement utilisée. Cependant, dans le cas des micro-écrans avec des pixels inférieurs à 10 μm, cette technique ne peut plus être utilisée à cause, non seulement, des problèmes d'alignement, mais aussi du temps nécessaire pour réaliser une telle technique à cette échelle.

Une autre solution consiste à réaliser la conversion de couleurs avec des boîtes quantiques (QD pour « Quantum Dot » en langue anglaise) ou des nanophosphores. Cependant, le contrôle du dépôt de ces matériaux sur des pixels de faibles dimensions est difficile et leur tenue au flux n'est pas suffisamment robuste.

Il est donc crucial de pouvoir obtenir les trois pixels RGB de façon native avec la même famille de matériaux et sur le même substrat. Pour cela, l'InGaN est le matériau le plus prometteur. Ce matériau peut, en effet, théoriquement couvrir tout le spectre visible en fonction de sa concentration en indium. Les micro-LEDs bleues à base d'InGaN montrent déjà une luminance élevée, bien supérieure à leurs homologues organiques. Pour émettre à des longueurs d'onde dans le vert, les puits quantiques (PQs) de la LED doivent contenir au moins 25% d'indium et pour une émission dans le rouge, il est nécessaire d'avoir au moins 35% d'indium. Malheureusement, la qualité du matériau InGaN au-delà de 20% d'In est dégradée en raison de la faible miscibilité de l'In dans le GaN, mais aussi en raison de la forte contrainte compressive inhérente à la croissance de la zone active InGaN sur GaN.

Il est donc essentiel de pouvoir réduire la contrainte globale dans les structures à base de GaN/InGaN.

Pour remédier à cette problématique, plusieurs solutions ont été envisagées.

Une première solution consiste à former des nanostructures, comme des nanofils ou des pyramides, pour pouvoir relaxer les contraintes par les bords libres. La croissance des nanofils axiaux peut être réalisée par épitaxie par jets moléculaires (ou MBE pour Molecular Beam Epitaxy »). En pratique, la faible température de croissance utilisée en croissance par MBE conduit à des faibles rendements quantiques internes (IQE). Les pyramides permettent de courber les dislocations. En particulier, les pyramides complètes ont des plans semi-polaires favorables à l'incorporation d'In et à la réduction du champ électrique interne de la zone active. Pour des pyramides tronquées, les faces tronquées permettent une croissance des puits quantiques sur le plan c, ce qui conduit à une émission plus homogène par rapport à une émission le long des plans semi-polaires d'une pyramide complète. Alternativement, la croissance peut aussi se faire en planaire sur des plans autres que la face c de la structure wurtzite comme la croissance sur les plans semi-polaires qui sont plus favorables à l'incorporation d'In.

Une autre solution consiste à réduire les contraintes dans la zone active de la structure LED en utilisant un substrat (ou pseudo-substrat) avec un paramètre de maille plus proche du paramètre de maille de l'alliage InGaN des puits quantiques. Ainsi, même avec une configuration planaire, on peut augmenter le taux d'incorporation d'In dans l'InGaN. Il a été montré que, lorsque le paramètre de maille du substrat augmente, le champ électrique interne est réduit et les émissions des puits quantiques sont décalées vers le rouge. La couche relaxée d'InGaN obtenue permet de faire croitre une hétérostructure III-N par épitaxie en phase vapeur aux organométalliques (ou MOVPE pour « metalorganic vapor phase epitaxy »). Cependant, à ce jour, à notre connaissance, le seul substrat ayant permis cette démonstration est le pseudo-substrat InGaNOS de Soitec. Il est fabriqué en mettant en œuvre la technique du Smart Cut™. La relaxation de la couche d'InGaN est obtenue à travers différents traitements thermiques [1]. Cependant, avec un tel procédé, des fissures peuvent apparaître dans la couche d'InGaN et/ou la surface de cette couche peut perdre sa planéité.

Une autre solution pour réduire les contraintes globales dans les structures LEDs à base de GaN/InGaN consiste à porosifier la couche de GaN. Dans la référence [2], on prépare dans un premier temps un empilement comprenant un substrat en saphir recouvert par une couche de GaN non intentionnellement dopée (GaN nid) et une couche de GaN dopée n+. La couche de GaN dopée joue le rôle d'anode. La cathode est un fil de platine. La porosification électrochimique est réalisée dans une solution d'acide oxalique (0,2M) en appliquant une tension de 15V pendant 30min, puis sous rayonnement ultraviolet dans une solution de KOH (0,06M) à 9V pendant 30min. La couche porosifiée de GaN ainsi obtenue permet de faire croitre une structure LED à puits quantiques multiples (MQWs pour « multiple quantum wells ») composée d'une couche de GaN n+, cinq puits quantiques (QP) Gan/InGaN et une couche de contact GaN p. La relaxation importante des contraintes conduit à de meilleures propriétés électriques et optiques, notamment en ce qui concerne la photoluminescence (PL).

Cependant, la qualité cristalline des couches de la LED dépend du diamètre des pores et de la porosité de la couche de GaN porosifiée, ainsi que de l'épaisseur recherchée. Il est donc nécessaire de trouver les paramètres adéquats à chaque fois, ce qui complique l'industrialisation du procédé.

## EXPOSÉ DE L'INVENTION

Un but de la présente invention est de proposer un procédé d'obtenir une couche d'InGaN épitaxiée, au moins partiellement voire totalement relaxée, à partir d'un substrat GaN/InGaN en vue de fabriquer, par exemple, des pixels rouge vert bleu.

Pour cela, la présente invention propose un procédé pour fabriquer une couche d'InGaN épitaxiée relaxée à partir d'un substrat GaN/InGaN comprenant les étapes suivantes :

a) fournir un premier empilement comprenant successivement un substrat initial, une couche de GaN, une couche d'InGaN dopée et une couche d'InGaN non intentionnellement dopée,

b) reporter la couche d'InGaN dopée et la couche d'InGaN non intentionnellement dopée sur un support d'anodisation, la couche d'InGaN non intentionnellement dopée étant en contact avec le support d'anodisation, de manière à former un deuxième empilement,

c) connecter la couche d'InGaN dopée et une contre-électrode à un générateur de tension ou de courant,

d) plonger le deuxième empilement et la contre-électrode dans une solution électrolytique,

e) appliquer une tension ou un courant, entre la couche d'InGaN dopée et la contre-électrode de manière à porosifier la couche d'InGaN dopée,

f) reporter la couche d'InGaN dopée porosifiée et la couche d'InGaN non intentionnellement dopée sur un support d'intérêt,

g) former une couche d'InGaN par épitaxie sur la couche d'InGaN non intentionnellement dopée, moyennant quoi on obtient une couche d'InGaN épitaxiée relaxée.

L'invention se distingue fondamentalement de l'art antérieur par la mise en œuvre d'une étape de porosification de la couche d'InGaN dopée, par voie électrochimique.

La porosification structure la surface de la couche d'InGaN et permet d'améliorer l'efficacité d'extraction et permet d'incorporer plus d'In par relaxation des contraintes.

Il est facile d'ajuster les dimensions des pores en fonction du dopage de la couche d'InGaN, de la tension appliquée et/ou de l'électrolyte choisi (nature et/ou concentration) pour avoir le pourcentage de relaxation nécessaire pour atteindre la longueur d'onde désirée.

Le premier report permet de réaliser l'étape de porosification sur la face de la couche d'InGaN de polarité azote (N), le degré de porosification est ainsi obtenu plus facilement. Le second report permet d'avoir une polarité gallium (Ga) en face avant du substrat, ce qui permet de réaliser ultérieurement une reprise d'épitaxie.

La couche d'InGaN non dopée ou faiblement dopée est électriquement isolante. Elle n'est pas porosifiée lors de l'étape e). Elle peut donc servir de couche de reprise d'épitaxie.

A l'issue du procédé, on obtient une structure de type InGaNOX (« InGaN on Substrate X») avec une couche d'InGaN non dopée, sans avoir besoin de mettre en œuvre un traitement thermique, et pleine plaque, i.e. sans avoir nécessairement à former des mesas.

Lors de la reprise d'épitaxie, la température de croissance utilisée (typiquement de 900°C à 1000°C) permet de modifier la couche porosifiée, notamment en élargissant les pores de cette couche, ce qui apporte un degré de liberté supplémentaire tout en conservant le paramètre de maille adapté à la couche ré-épitaxiée. La reprise d'épitaxie permet donc de relaxer encore plus la couche d'InGaN non intentionnellement dopée. On obtient ainsi une couche d'InGaN au moins partiellement relaxée, et de préférence totalement relaxée.

Avantageusement, le support d'anodisation et/ou le support d'intérêt comprend une couche support, par exemple en saphir ou en silicium, et une couche d'oxyde enterré.

Selon un mode de réalisation particulier, l'étape b) est, avantageusement, réalisée selon un procédé, de type SmartCut™, comprenant les étapes suivantes :

- implantation d'espèces atomiques pour former une zone de fragilisation dans la couche d'InGaN dopée, à une profondeur voisine de l'épaisseur finale de la couche à conserver dans le substrat final,
- collage du premier empilement sur le support d'anodisation, la couche d'InGaN non dopée étant en contact avec le support d'anodisation,
- apport d'énergie thermique pour désolidariser la couche d'InGaN dopée de la couche de GaN au niveau de la zone de fragilisation.

Avantageusement, le premier empilement comprend en outre une couche de GaN fortement dopée, disposée entre la couche de GaN non intentionnellement dopée et la couche d'InGaN dopée.

Selon ce mode de réalisation, l'étape b) peut être réalisée selon deux variantes avantageuses.

Selon la première variante de réalisation avantageuse, l'étape b) comporte les étapes suivantes :

- anodisation électrochimique sur la couche de GaN fortement dopée pour la fragiliser,

- séparation de la couche d'InGaN dopée et de la couche d'InGaN non intentionnellement dopée de la couche de GaN fortement dopée par activation thermique et/ou action mécanique.

Selon la deuxième variante de réalisation avantageuse, l'étape b) comporte une étape au cours de laquelle on réalise une anodisation électrochimique sur la couche de GaN fortement dopée jusqu'à sa dissolution, moyennant quoi on sépare la couche d'InGaN dopée et la couche d'InGaN non intentionnellement dopée de la couche de GaN dopée. La dissolution de la couche de GaN dopée peut être réalisée préalablement ou ultérieurement au report des couches d'InGaN sur le support d'anodisation.

Avantageusement, le procédé comporte une étape ultérieure au cours de laquelle on structure la couche d'InGaN dopée et la couche d'InGaN non intentionnellement dopée, par exemple par photolithographie, pour former des mésas d'InGaN. La formation des mésas permet d'introduire un degré de relaxation supplémentaire au niveau des bords libres des mésas.

Avantageusement, le procédé comprend une étape au cours de laquelle on réalise une étape de dopage par implantation ou par épitaxie en phase vapeur aux organométalliques éventuellement avec différents dopages, sur les mésas d'InGaN. Par exemple, on peut réaliser une implantation Si (ou dopant de type n) avec des dopages différents d'une mésa à l'autre. On obtient ainsi des pixels, par exemple trois pixels, de niveaux de dopages différents et donc par suite des pourcentages de relaxation différents, et ainsi des longueurs d'onde d'émission différentes. Cette variante de réalisation est avantageuse pour former un dispositif multispectral, par exemple des LEDs de différentes couleurs de façon simplifiée ou micro-écran (« micro-display ») multi couleurs.

Selon une autre alternative avantageuse, le procédé comporte, entre l'étape b) et l'étape c), une étape au cours de laquelle on structure la couche d'InGaN dopée et la couche d'InGaN non intentionnellement dopée, par exemple par photolithographie, pour former des mésas d'InGaN. Les mésas sont ainsi formées avant l'étape de porosification, ce qui permet de porosifier les mésas à la fois par les faces latérales des mésas et par la face supérieure en contact avec la solution électrolytique.

Selon cette autre alternative avantageuse, le procédé comprend, avantageusement, une étape, avant l'étape c), au cours de laquelle on réalise une étape de dopage par implantation ou par épitaxie en phase vapeur aux organométalliques, éventuellement avec différents dopages, sur les mésas d'InGaN. Il est par exemple possible de réaliser une implantation sélective d'un dopant n (tel que du silicium) ou un dopant p (tel que magnésium) pour obtenir des mésas plus ou moins dopées, ce qui conduira à des mésas plus ou moins relaxées lors de l'étape de porosification.

Selon une variante plus avantageuse, il est possible de réaliser l'étape d'implantation avant la formation des mésas.

Avantageusement, les mésas ont une épaisseur inférieure à 100nm. Ainsi, la densité de défauts dans les mésas est limitée malgré la forte concentration en In.

Avantageusement, la couche d'InGaN non dopée ou faiblement dopée a une épaisseur inférieure à 3nm.

Avantageusement, le taux d'indium présent dans la couche d'InGaN est supérieur ou égal à 8%. Ceci assure une ré-épitaxie de qualité, riche en In.

Ce procédé présente de nombreux avantages :

- il est simple à mettre en œuvre,
- il peut être utilisé pour des mésas de faibles épaisseurs (typiquement inférieures à 100nm),
- la structuration en mésa apporte l'effet de compliance,
- il conduit à une relaxation totale des contraintes, ce qui conduit à diminuer la polarisation piézo-électrique par comparaison à une couche contrainte de même concentration en In, et surtout à incorporer plus d'In pour les mêmes conditions de croissance,
- il permet une approche dite « bottom up » pour la fabrication de µLED et µdisplay : la croissance des structures optiques (N, QW, P) est réalisée après pixellisation en mésa, quel que soit la taille des pixels, et permet de s'affranchir des problèmes d'alignement comme pour le procédé « pick and place »,
- il n'y a pas d'impact du procédé de gravure des pixels sur l'efficacité des micro-LEDs, ce qui rend possible la réalisation de pixel micrométrique voire submicrométrique.

Avec ce procédé, il est possible d'atteindre 40% d'In dans les puits et une efficacité quantique (EQE) supérieure à 2,9 % dans le rouge.

L'invention concerne également un substrat comprenant successivement :

- un support d'intérêt,
- une couche d'InGaN dopée et poreuse, ayant, avantageusement, une porosité supérieure à 1%, et de préférence, de 5% à 70%,
- une couche d'InGaN non intentionnellement dopée.

La couche d'InGaN non intentionnellement dopée n'est pas poreuse.

Avantageusement, le support d'intérêt comprend une couche support, par exemple en saphir, en SiC ou en silicium, et une couche d'oxyde enterré.

L'invention concerne également une structure de diode électroluminescente comprenant successivement un substrat et un empilement réépitaxié, le substrat comprenant :

- un support d'intérêt,

- une couche d'InGaN dopée et poreuse, ayant, avantageusement, une porosité supérieure à 1%, et de préférence, de 5% à 70%,
- une couche d'InGaN non intentionnellement dopée,

l'empilement réépitaxié comprenant successivement depuis la couche d'InGaN non intentionnellement dopée du substrat :

- une couche d'InGaN épitaxiée relaxée dopée d'un premier type de conductivité,
- une zone active avec un ou plusieurs puits quantiques InGaN/(Ga,In)N émettant dans le rouge, dans le vert ou dans le bleu
- une couche d'InGaN dopée d'un second type de conductivité, différent du premier type de conductivité.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

Les figures 1A, 1B, 1C et 1D représentent, de manière schématique, en coupe, différentes étapes d'un procédé de fabrication d'un substrat, comprenant une couche d'InGaN, au moins partiellement relaxé, selon un mode de réalisation particulier de l'invention.

Les figures 2A, 2B, 2C, 2D et 2E représentent, de manière schématique, en coupe, différentes étapes d'un procédé de fabrication d'un substrat, comprenant une couche d'InGaN, au moins partiellement relaxée, selon un mode de réalisation particulier de l'invention.

La figure 3 est un graphique représentant différents phénomènes intervenant (pré-porosification (ou « pre-breakdown »), porosification, et électropolissage) lors d'une étape d'anodisation, en fonction du taux de dopage et du potentiel appliqué, selon un mode de réalisation particulier de l'invention.

Les figures 4A, 4B, 4C, 4D et 4E représentent de manière schématique, en coupe, différentes étapes d'un procédé de fabrication d'un substrat, comprenant une couche d'InGaN, au moins partiellement relaxée, selon un mode de réalisation particulier de l'invention.

La figure 5 représente de manière schématique, en coupe, une micro-LED selon un mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », «dessous», etc. d'une structure s'appliquent en considérant que la structure est orientée de la façon illustrée sur les figures.

**EXPOSÉ DÉTAILLÉ DE MODES DE RÉALISATION PARTICULIERS**

Bien que cela ne soit aucunement limitatif, l'invention trouve particulièrement des applications dans le domaine des micro-écrans couleurs, et plus particulièrement pour la fabrication des pixels rouge vert bleu. Cependant, elle pourrait être utilisée dans le domaine du photovoltaïque ou encore de l'électrolyse de l'eau (« water splitting ») puisque, d'une part, l'InGaN absorbe dans tout le spectre visible et que, d'autre part, ses bandes de valence et de conduction sont autour du domaine de stabilité de l'eau, conditions thermodynamiques nécessaires à la décomposition de l'eau. L'invention peut également être intéressante pour la fabrication de LED ou de laser émettant à grande longueur d'onde.

Le procédé, permettant d'obtenir un substrat ou un pseudo-substrat, comprenant une couche d'InGaN non intentionnellement dopée 14, au moins partiellement relaxée, sur une couche d'InGaN dopée 13, comprend une étape au cours de laquelle on porosifie la couche d'InGaN dopée 13 par anodisation électrochimique.

Par partiellement relaxé, on entend que le paramètre de maille a de la couche d'InGaN non intentionnellement dopée 14 est supérieur au paramètre de maille a de la couche de GaN sur saphir, ce qui permet d'incorporer plus d'In.

Le pourcentage de relaxation correspond à :

$$\Delta a/a = (a_{c2} - a_{c1})/a_{c1}$$

avec $a_{c1}$, le paramètre de maille de la couche de départ, et
$a_{c2}$ le paramètre de maille de la couche relaxée

La couche est relaxée à 100% si $a_{c2}$ correspond au paramètre de maille du matériau massif.

Lorsque $a_{c1}=a_{c2}$ le couche est dite contrainte.

Par partiellement relaxée, on entend un pourcentage de relaxation supérieure à 50%.

Plus particulièrement, le procédé comprend les étapes suivantes :

a) fournir un premier empilement 10 comprenant successivement un substrat initial 11, une couche de GaN 12, une couche d'InGaN dopée 13 et une couche d'InGaN non intentionnellement dopée 14,

b) reporter la couche d'InGaN dopée 13 et la couche d'InGaN non intentionnellement dopée 14 sur un support d'anodisation 21, la couche d'InGaN non intentionnellement dopée 14 étant en contact avec le support d'anodisation 21, de manière à former un deuxième empilement 20,

c) connecter la couche d'InGaN dopée 13 et une contre-électrode à un générateur de tension ou de courant,

d) plonger le deuxième empilement 20 et la contre-électrode dans une solution électrolytique,

e) appliquer une tension ou un courant, entre la couche d'InGaN dopée 13 et la contre-électrode de manière à porosifier la couche d'InGaN dopée 13,

f) reporter la couche d'InGaN dopée 13 porosifiée et la couche d'InGaN non intentionnellement dopée 14 sur un support d'intérêt 31,

g) former une couche d'InGaN par épitaxie sur la couche d'InGaN non intentionnellement dopée, moyennant quoi on obtient une couche d'InGaN épitaxiée relaxée,

h) éventuellement, former des mésas de taille micrométrique (par exemple de 1 $\mu$m à plusieurs dizaines de micromètres, et de préférence de 5 à 10 $\mu$m de côté) pour augmenter le pourcentage de relaxation, par relaxation par les bords libres des mésas.

L'étape h) peut être réalisée entre l'étape b) et l'étape c) ou encore après l'étape g).

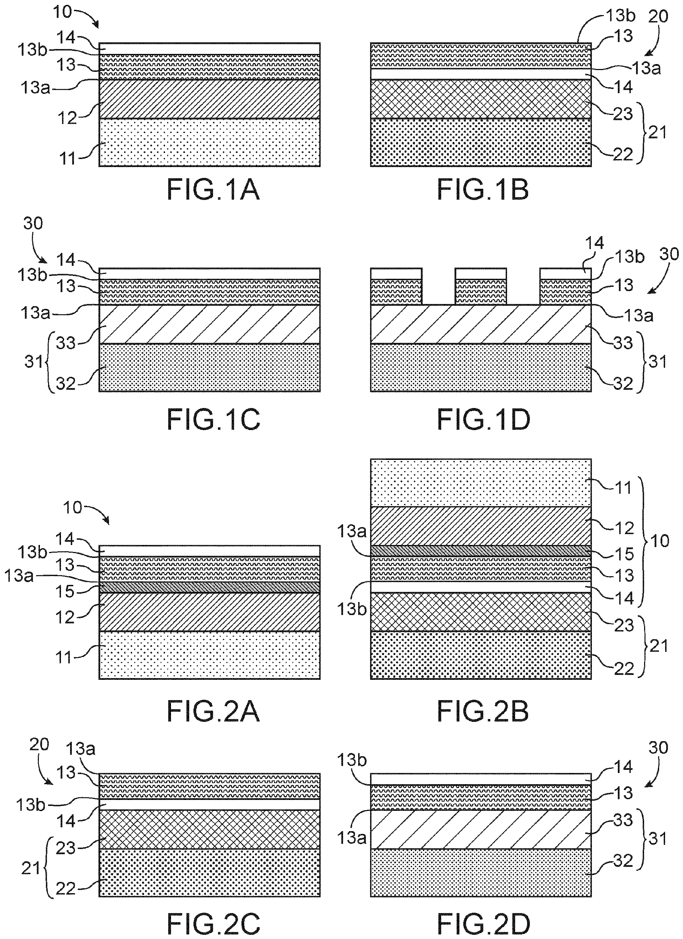

On se réfère tout d'abord aux figures 1A à 1D.

Le premier empilement 10 fourni à l'étape a) et, représenté sur la figure 1A, comprend un substrat initial 11, par exemple, en saphir, en SiC, en silicium ou en verre. Le substrat 11 a, par exemple, une épaisseur allant de 350 $\mu$m à 1,5 mm.

La couche de GaN 12 a, par exemple, une épaisseur allant de 30 nm à 4 $\mu$m. La couche de GaN est non intentionnellement dopée. Par GaN non intentionnellement dopée, on entend une concentration de dopage inférieure à $5.10^{17}/cm^3$.

La couche d'InGaN dopée 13 est dopée n. Elle a, par exemple, une épaisseur allant de 10 à 200 nm. Par InGaN dopée, on entend une concentration en électrons comprise entre $2.10^{18}$ et $2.10^{19}/cm^3$. La couche d'InGaN dopée 101 est électriquement conductrice. Elle est porosifiée lors de l'étape e).

La couche d'InGaN dopée 13 a deux faces principales : une première face principale 13a et une deuxième face principale 13b. La première face principale 13a est de polarité azote (N). Elle est disposée en regard de la couche de GaN 12. La deuxième face principale 13b est de polarité Gallium (Ga). Elle est disposée en contact avec la couche d'InGaN non intentionnellement dopée 14.

La couche d'InGaN non intentionnellement dopée 14 a, de préférence, une épaisseur inférieure à 3 nm, par exemple, une épaisseur de 1 nm. Par InGaN non intentionnellement dopée, on entend une concentration de dopage inférieure à $5.10^{17}/cm^3$. Cette couche est électriquement isolante. Elle n'est pas porosifiée lors de l'étape e). A l'issue de l'étape e), la couche d'InGaN non intentionnellement dopée 14 n'est pas poreuse (c'est-à-dire qu'elle a une porosité inférieure à 0,01%, et de préférence inférieure à 0,001%).

De préférence, le premier empilement 10 est constitué des couches précédemment citées. Autrement dit, il ne comporte pas d'autres couches.

Ces couches sont, avantageusement, déposées pleine plaque sur le substrat initial 11.

Lors de l'étape b), on transfert la couche d'InGaN dopée 13 et la couche d'InGaN non intentionnellement dopée 14 sur un support d'anodisation 21 (figure 1B).

La face libre de la couche d'InGaN non intentionnellement dopée 14 est reportée, de préférence, sur la couche d'oxyde 23 BOX du support d'anodisation 21, via par exemple un collage direct ou moléculaire.

Le support d'anodisation 21 comprend, avantageusement, une couche support 22 et une couche d'oxyde enterré 23 dite BOX (« Buried Oxide layer » aussi parfois appelée couche continue d'oxyde).

La couche support (ou support) 22 est, par exemple, en saphir, en silicium ou en verre. La couche support 22 a, par exemple, une épaisseur allant de 350 $\mu$m à 1,5 mm.

La couche d'oxyde 23 BOX a, par exemple, une épaisseur allant de 100 nm à 4 $\mu$m.

Selon un mode de réalisation avantageux, ce transfert est réalisé par la technique du Smart Cut™. Pour cela, le procédé comporte les étapes suivantes :

- implantation d'espèces atomiques pour former une zone de fragilisation dans la couche d'InGaN dopée, à une profondeur voisine de l'épaisseur finale de la couche à conserver dans le substrat final ;
- collage du premier empilement 10 sur le support d'anodisation 21,
- apport d'énergie thermique pour désolidariser la couche d'InGaN dopée au niveau de la zone de fragilisation.

Le substrat initial 11 et la couche de GaN non intentionnellement dopée 12 du premier empilement 10 sont détachés de la couche d'InGaN dopée 13 par fracture le long du plan de la zone de fragilisation. La fracture est réalisée par exemple, par traitement thermique dans une gamme de température allant de 400°C à 600°C et pendant une durée allant de quelques minutes à quelques heures. Cette fracture conduit au report de la couche d'InGaN dopée 13 et de la couche d'InGaN non intentionnellement 14 dopée sur le support d'anodisation 21.

Selon un mode de réalisation particulier, le substrat initial 11 et la couche de GaN non intentionnellement dopée 12 peuvent être détachés de la couche d'InGaN dopée 13 par un procédé de gravure d'une couche intermédiaire sacrificielle par exemple avec un laser (aussi appelée technique de décollement ou « lift off »).

A l'issue de l'étape b), on obtient ainsi un deuxième empilement 20 comprenant successivement la couche support 22, la couche d'oxyde enterré 23, la couche d'InGaN non intentionnellement dopée 14, la couche d'InGaN dopée 13 (figure 1B). La première face 13a de polarité N est ainsi accessible.

Après implantation du Smart Cut™, et avant l'étape d'anodisation, il est possible de réaliser une étape d'implantation Si pour rendre la couche InGaN dopée 13 encore plus électriquement conductrice.

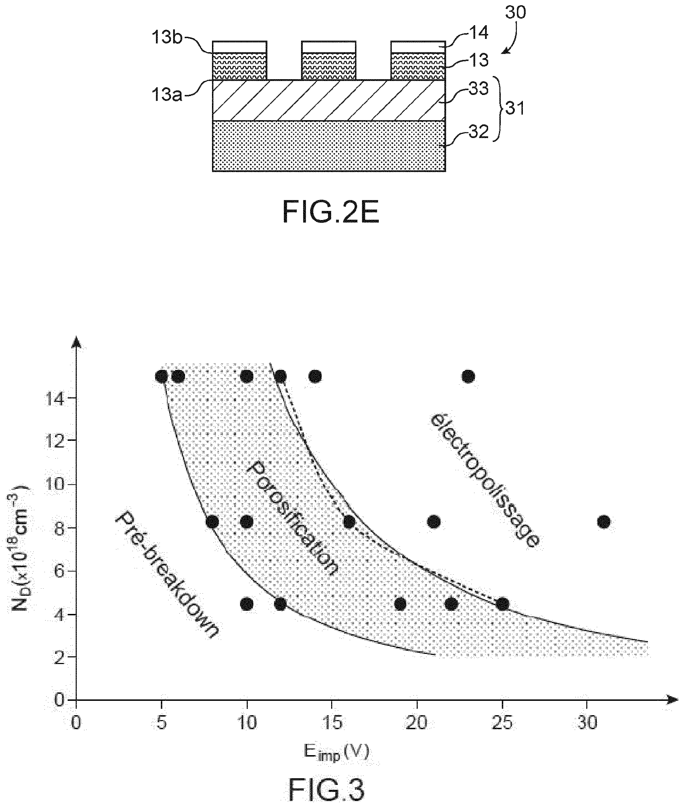

Selon une autre variante du procédé de réalisation, représentée sur les figures 2A à 2E, le premier empilement 10 peut, en outre comprendre, une couche de GaN fortement dopée 15, notée GaN n++, disposée entre la couche de GaN 12 et la couche d'InGaN dopée 13.

La couche de GaN fortement dopée 15 a, par exemple, une épaisseur allant de 10 à 200 nm. Par GaN fortement dopée, on entend un dopage supérieur ou égal à $10^{19}$/cm$^3$.

Avantageusement, selon cette variante de réalisation, après report du premier empilement 10 sur le support d'anodisation 21 lors de l'étape b) (figure 2B), la couche de GaN fortement dopée 15 est séparée de la couche d'InGaN dopée 14 en réalisant une anodisation électrochimique sur la couche de GaN fortement dopée 15 de manière à la porosifier (figure 2C). La couche de GaN fortement dopée 15 est utilisée comme membrane. La différence du taux de dopage permet d'avoir une forte sélectivité entre la porosification et l'électropolissage (figure 3).

Avantageusement, la séparation est facilitée avec une activation thermique et/ou mécanique.

Alternativement, l'étape d'anodisation sur la couche de GaN dopée 15 peut être réalisée préalablement à l'étape b) de report, par exemple s'il est nécessaire d'appliquer une contrainte mécanique pour désolidariser la couche.

Lorsque l'étape de porosification de la couche de GaN dopée 15 est réalisée avant l'étape b), on contrôle le taux de porosification afin de maintenir la cohérence de l'ensemble de l'empilement. Après report, on applique une contrainte thermique et/ou mécanique pour séparer le dispositif en deux parties, avantageusement au niveau de l'interface la plus fragile, i.e. entre la couche de GaN fortement dopée et la couche d'InGaN dopée.

L'étape de porosification de la couche de GaN fortement dopée 15 peut être réalisée en utilisant le même bain électrolytique (nature et/ou concentration) et/ou la même tension (ou le même courant appliqué) que lors de l'étape de porosification de la couche d'InGaN dopée 13 (étape e).

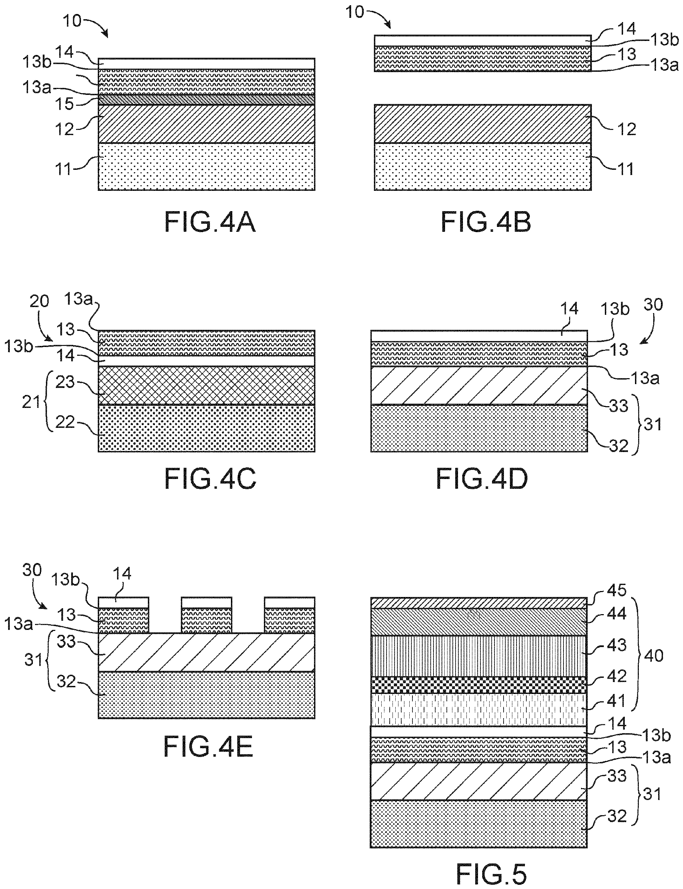

Selon une autre variante de réalisation représentée sur les figures 4A à 4E, le premier empilement comprend une couche de GaN fortement dopée 15, disposée entre la couche de GaN 12 et la couche d'InGaN dopée (figure 4A). L'étape b) est réalisée selon les étapes suivantes :

- connecter la couche de GaN dopée 15 et une contre-électrode à un générateur de tension ou de courant,
- plonger le premier empilement 10 et la contre-électrode dans une solution électrolytique,
- appliquer une tension ou un courant, entre la couche de GaN fortement dopée 15 et la contre-électrode de manière à graver la couche de GaN fortement dopée 15, moyennant quoi on désolidarise la couche d'InGaN non intentionnellement dopée 14 et la couche d'InGaN dopée 13 de la couche de GaN 12 (figure 4B).

On obtient ainsi une membrane d'InGaN.

On reporte ensuite les couches d'InGaN dopée 13 et d'InGaN non intentionnellement dopée 14 sur le support d'anodisation 21 (étape b - figure 4C).

Dans ce mode de réalisation, on grave latéralement la couche GaN n++ 15. Avantageusement, ce mode de réalisation du procédé ne met pas en œuvre une étape supplémentaire pour désolidariser les couches d'InGaN 13, 14 des autres couches du premier empilement 10. Cette variante de réalisation est, avantageusement, utilisée pour des échantillons de petites dimensions (typiquement jusqu'à quelques cm$^2$). Sur de plus grandes surfaces, on pourra former préalablement des chemins d'accès pour l'électrolyte au sein de la couche de GaN dopée 15.

Suite au report de la couche d'InGaN dopée 13 et de la couche d'InGaN non dopée 14, on réalise une anodisation électrochimique sur la couche d'InGaN dopée 13. L'anodisation peut permettre de relaxer partiellement la couche d'InGaN dopée 13.

Pour cela, lors de l'étape c), le deuxième empilement 20 et une contre-électrode (CE) 500 sont électriquement reliés à un générateur de tension ou de courant. Le deuxième empilement 20 joue le rôle d'électrode de travail (WE). Par la suite, on le dénommera générateur de tension, mais il pourrait s'agir d'un générateur de courant permettant d'appliquer un courant entre le dispositif et la contre-électrode.

La contre-électrode 500 est en un matériau électriquement conducteur, comme par exemple un métal tel que le platine.

Lors de l'étape d), les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, HNO$_3$ ou H$_2$SO$_4$.

Il est possible de réaliser l'étape d) avant l'étape c).

Lors de l'étape e), on applique une tension entre le dispositif et la contre-électrode 500. La tension peut aller de 1V à 100V, de préférence de 3V à 100 V. Elle est appliquée, par exemple, pendant une durée allant de quelques secondes à quelques heures. La réaction d'anodisation est finie lorsque, à potentiel imposé, le courant devient nul : dans ce cas il n'y a plus de transfert de charges et la réaction électrochimique s'arrête.

L'étape d'anodisation électrochimique peut être réalisée sous lumière ultra-violette (UV). Le procédé peut également comporter une première anodisation électrochimique sans ajouter de rayonnement ultra-violet et une seconde anodisation électrochimique en ajoutant un rayonnement ultra-violet.

Avantageusement, la porosification a lieu dans tout le volume de la couche d'InGaN dopée 13.

A l'issue de l'étape de porosification, le taux de porosité de la couche d'InGaN dopée 13 est d'au moins 1%. Il va de préférence de 5% à 70%

La plus grande dimension (la hauteur) des pores peut varier de quelques nanomètres à quelques micromètres. La plus petite dimension (le diamètre) peut varier de quelques nanomètres à une centaine de nanomètres, en particulier de 10nm à 70nm, par exemple de 30 à 70nm, et de préférence de 15nm à 40nm.

La porosification obtenue (taux de porosité et taille des pores) dépend du dopage de la couche d'InGaN dopée 13 et des paramètres du procédé (tension appliquée, durée, nature et concentration de l'électrolyte). La variation de la porosification permet de contrôler le taux d'incorporation / ségrégation. La porosification, et en particulier, la taille des pores, pourra varier ultérieurement, lors de la reprise d'épitaxie en fonction de la température appliquée.

L'étape de porosification permet d'avoir une couche d'InGaN non intentionnellement dopée 14, totalement ou partiellement relaxée, sur une couche d'InGaN 13 qui après porosification est moins dopée voire n'est plus du tout dopée.

Pour avoir la deuxième face 13b de polarité métal (Gallium) en face avant, on reporte le deuxième empilement 20 sur un support d'intérêt 31, comprenant, par exemple, une couche support 32 de préférence en Si, SiC, verre ou saphir, et une couche d'oxyde BOX 33 (étape f).

L'étape f) peut être réalisée avec la technique SmartCut™, selon les étapes suivantes :

- implantation d'espèces atomiques pour former une zone de fragilisation dans la couche d'InGaN non intentionnellement dopée, à une profondeur voisine de l'épaisseur finale de la couche à conserver dans le substrat final ;
- collage de la couche d'InGaN non intentionnellement dopée sur le support d'intérêt 31,
- apport d'énergie thermique pour désolidariser la couche d'InGaN non intentionnellement dopée au niveau de la zone de fragilisation.

On obtient ainsi à l'issue du procédé un substrat 30 de type InGaNOX (« InGaN on substrate X ») comprenant (figures 1C, 2D, 4D) depuis la face arrière vers la face avant :

- un support d'intérêt 31, par exemple, formé d'une couche support 32, de préférence en saphir, et d'une couche d'oxyde BOX 33,
- une couche d'InGaN dopée 13, porosifiée, avec une polarité Ga en face avant,
- une couche d'InGaN non intentionnellement dopée 14, non poreuse, au moins partiellement voire totalement relaxée.

Selon une variante de réalisation avantageuse, le procédé peut comporter une étape ultérieure (étape h)) au cours de laquelle on structure la couche d'InGaN porosifiée et la couche d'InGaN non intentionnellement dopée pour former des mésas d'InGaN (figure 1D, 2E, 4E).

Selon une autre variante de réalisation avantageuse, les mésas peuvent être formées avant l'étape de porosification.

Les mésas peuvent être structurées puis dopées. Selon cette variante de réalisation, le procédé peut comporter, avant l'étape de porosification, les étapes suivantes :

- structurer la couche d'InGaN et la couche d'InGaN non intentionnellement dopée, déposées pleine plaque, pour former des mésas d'InGaN,
- avantageusement, remplir l'espace entre les mésas avec un matériau adapté et planariser l'ensemble ainsi obtenu pour avoir une surface plane,
- implanter localement un dopant dans les mésas à la même concentration ou à des concentrations différentes ; il est par exemple possible de réaliser plusieurs implantations avec des jeux de masques différents.

Alternativement, le dopage peut être réalisé préalablement à la structuration des mésas. Selon cette variante de réalisation, le procédé peut comporter, avant l'étape de porosification, les étapes suivantes :

- implanter localement un dopant dans la couche d'InGaN dopée déposée pleine plaque, la concentration en dopant pouvant varier le long de la couche d'InGaN de manière à former des zones plus ou moins dopées,
- structurer la couche d'InGaN et la couche d'InGaN non intentionnellement dopée, déposées pleine plaque, pour former des mésas d'InGaN.

A titre illustratif, il est, par exemple, possible d'utiliser un masque dur, comme un masque de type SiN ou $SiO_2$, pour réaliser l'implantation et des marques d'alignement (par exemple en Al, Ti, TiN) pour faire correspondre les mésas et les zones implantées. Avec deux masques différents, deux zones avec des énergies d'implantation différentes peuvent être réalisées, et donc deux dopages différents en plus du dopage initial de la plaque dopée, par exemple par MOCVD. Les marques d'alignement permettent d'aligner les deux masques pour l'implantation et le masque pour la gravure des mésas.

Le même jeu de masque sera utilisé pour l'implantation et les mésas.

La structuration des mésas peut être réalisée par photolithographie.

Les mésas, aussi appelées élévations, sont des éléments en relief. Elles sont obtenues, par exemple, par gravure d'une couche continue ou de plusieurs couches continues superposées, de manière à ne laisser subsister qu'un certain nombre de "reliefs" de cette couche ou de ces couches. La gravure est généralement une gravure plasma ou sèche (ex : RIE plasma). Les reliefs permettent de définir des pixels.

De préférence, les flancs des mésas sont perpendiculaires à l'empilement des différentes couches du substrat 30.

Les dimensions (largeur et longueur) des mésas vont de 500nm à 500$\mu$m. Par largeur et longueur, on entend les dimensions parallèles à la surface de l'empilement sous-jacent.

L'espacement (« pitch ») entre deux mésas 100 consécutives va de 50nm à 20$\mu$m.

Les mésas d'InGaN comprennent une couche d'InGaN dopée 13 et une couche d'InGaN non intentionnellement dopée 14. De préférence, les mésas sont constituées de ces deux couches 13, 14.

La couche d'InGaN dopée 13 des mésas a, avantageusement, une épaisseur allant de 10 nm à 200 nm. Une couche de faible épaisseur (inférieure à 100nm) peut contenir une concentration en In élevée tout en conservant une bonne qualité matériau (peu de défaut). Par épaisseur, on entend la dimension de la mésa perpendiculaire à l'empilement sous-jacent.

Alternativement, le dopage par implantation peut être remplacé par un dopage par épitaxie en phase vapeur aux organométalliques (MOCVD), avec comme dopant Si ou Ge notamment. Il est, par exemple, possible de réaliser trois étapes d'épitaxie successives pour obtenir 3 niveaux de dopages différents afin de former à la fin du procédé des mésas bleues, vertes et rouges (RGB).

Le procédé comprend une étape ultérieure au cours de laquelle on réalise un empilement réépitaxié 40 soit sur la couche d'InGaN non intentionnellement dopée 14 pleine plaque (figure 5) soit sur la couche d'InGAN non intentionnellement dopée 14 des mésas d'InGaN. Cette étape est avantageusement réalisée pour former des LED ré-épitaxiées, en particulier des LED rouges (ou vertes) tout InGaN.

La couche d'InGaN non intentionnellement dopée 14 est une couche 2D continue non poreuse puisqu'elle n'est pas porosifiée lors de l'étape d'anodisation électrochimique. L'empilement réépitaxié 40 est ainsi facilitée et la couche épitaxiée présente une meilleure tenue.

L'empilement réépitaxié 40 d'une LED tout In-GaN comprend, par exemple, successivement depuis la couche d'InGaN non intentionnellement dopée 14 :

- une couche d'InGaN dopée n 41, de préférence de même concentration en In que la couche d'InGaN du substrat relaxé,
- une zone active 42 avec un ou plusieurs puits quantiques InGaN/(Ga,In)N émettant dans le rouge (ou vert),
- une barrière à électron 43 à base de GaN ou d'AlGaN dopée p
- une couche d'InGaN dopée p 44, de préférence de même concentration en In que la couche de n-InGaN ou inférieure,
- une couche d'InGaN dopée p++ 45, de préférence de même concentration en In que la couche de p-InGaN.

Plus particulièrement, une structure LED tout InGaN peut comprendre successivement :

- un substrat InGaN,
- une couche d'InGaN dopée n de 350nm, formée de 15 x $In_{0,03}Ga_{0,97}N$ / GaN (épaisseurs 20nm / 1,8nm),
- des puits quantiques multiples (MQWs), formés de 5 x $In_{0,40}Ga_{0,60}N$ / $In_{0,03}Ga_{0,097}N$ (épaisseurs 2,3nm / 5, 7, 11 nm),
- une couche de $In_{0,03}Ga_{0,97}N$ nid (10nm),
- une couche $Al_{0,1}Ga_{0,9}N$ :Mg (20nm),
- une couche de $In_{0,03}Ga_{0,97}N$ dopée Mg (125nm),
- une couche de $In_{0,03}Ga_{0,97}N$ dopée p+++ (25nm).

Différents procédés de croissance peuvent être utilisés pour former des couches épitaxiées.

Selon une première variante de réalisation, la reprise de croissance est latérale et une étape de pixellisation ultérieure par gravure est avantageusement réalisée.

Selon une autre variante de réalisation, la reprise de croissance se fait verticalement au-dessus des mésas. Dans cette variante, les pixels correspondent aux mésas sous-jacentes.

Avantageusement, une couche de passivation sera déposée sur les flancs des mésas 100 et/ou des LED ré-épitaxiées par exemple par dépôt de couche atomique (ALD). La couche de passivation peut être en alumine. La couche de passivation peut avoir une épaisseur de quelques nanomètres, par exemple de 2 à 5nm.

## REFERENCES

[1] Even et al., "Enhanced In incorporation in full In-GaN heterostructure grown on relaxed InGaN pseudo-substrate », Appl. Phys. Lett. 110, 262103 (2017).

[2] Jang et al., "Electrical and structural properties of GaN films and GaN/InGaN light-emitting diodes grown on porous GaN templates fabricated by combined electrochemical and photoelectrochemical etching", Journal of Alloys and Compounds 589 (2014) 507-512.

**Revendications**

1. Procédé pour fabriquer une couche d'InGaN épitaxiée relaxée à partir d'un substrat GaN/InGaN comprenant les étapes suivantes :

   a) fournir un premier empilement (10) comprenant successivement un substrat initial (11), une couche de GaN (12), une couche d'InGaN dopée (13) et une couche d'InGaN non intentionnellement dopée (14),
   b) reporter la couche d'InGaN dopée (13) et la couche d'InGaN non intentionnellement dopée (14) sur un support d'anodisation (21), la couche d'InGaN non intentionnellement dopée (14) étant en contact avec le support d'anodisation (21), de manière à former un deuxième empilement (20),
   c) connecter la couche d'InGaN dopée (13) et une contre-électrode à un générateur de tension ou de courant,
   d) plonger le deuxième empilement (20) et la contre-électrode dans une solution électrolytique,
   e) appliquer une tension ou un courant, entre la couche d'InGaN dopée (13) et la contre-électrode de manière à porosifier la couche d'InGaN dopée (13),
   f) reporter la couche d'InGaN dopée (13) porosifiée et la couche d'InGaN non intentionnellement dopée (14) sur un support d'intérêt (31),
   g) former une couche d'InGaN par épitaxie sur la couche d'InGaN non intentionnellement dopée, moyennant quoi on obtient une couche d'InGaN épitaxiée relaxée.

2. Procédé selon la revendication 1, **caractérisé en ce que** le support d'anodisation (21) et/ou le support d'intérêt (31) comprend une couche support (22, 32), par exemple en saphir ou en silicium, et une couche d'oxyde enterré (23, 33).

3. Procédé selon l'une des revendications 1 et 2, **caractérisé en ce que** le premier empilement (10) comprend en outre une couche de GaN fortement dopée (15), disposée entre la couche de GaN dopée non intentionnellement dopée (12) et la couche d'InGaN dopée (13).

4. Procédé selon la revendication 3, **caractérisé en ce que** l'étape b) est réalisée selon les étapes suivantes :

   - anodisation électrochimique sur la couche de GaN fortement dopée (15) pour la fragiliser,
   - séparation de la couche d'InGaN dopée (13) et de la couche d'InGaN non intentionnellement dopée (14) de la couche de GaN fortement dopée (15) par activation thermique et/ou action mécanique.

5. Procédé selon la revendication 3, **caractérisé en ce que** l'étape b) comporte une étape au cours de laquelle on réalise une anodisation électrochimique sur la couche de GaN fortement dopée (15) jusqu'à sa dissolution, moyennant quoi on sépare la couche d'InGaN dopée (13) et de la couche d'InGaN non intentionnellement dopée (14) de la couche de GaN dopée (13).

6. Procédé selon l'une des revendications 1 à 3, caractérisé en ce l'étape b) est réalisée selon un procédé comprenant les étapes suivantes :

   - implantation d'espèces atomiques pour former une zone de fragilisation dans la couche d'InGaN dopée (13), à une profondeur voisine de l'épaisseur finale de la couche à conserver dans le substrat final (30),
   - collage du premier empilement (10) sur le support d'anodisation (21), la couche d'InGaN non dopée (14) étant en contact avec le support d'anodisation (21),
   - apport d'énergie thermique pour désolidariser la couche d'InGaN dopée (13) de la couche de GaN (12) au niveau de la zone de fragilisation.

7. Procédé selon l'une quelconque des revendications 1 à 6, **caractérisé en ce que** le procédé comporte une étape ultérieure au cours de laquelle on structure la couche d'InGaN dopée (13) et la couche d'InGaN non intentionnellement dopée (14), par exemple par photolithographie, pour former des mésas d'InGaN.

8. Procédé selon la revendication précédente, **caractérisé en ce que** le procédé comprend une étape au cours de laquelle on réalise une étape de dopage par implantation ou par épitaxie en phase vapeur aux organométalliques, éventuellement avec différents dopages, sur les mésas d'InGaN.

9. Procédé selon l'une quelconque des revendications 1 à 6, **caractérisé en ce que** le procédé comporte, entre l'étape b) et l'étape c), une étape au cours de laquelle on structure la couche d'InGaN dopée (13) et la couche d'InGaN non intentionnellement dopée (14), par exemple par photolithographie, pour former des mésas d'InGaN.

**10.** Procédé selon la revendication précédente, **caractérisé en ce que** le procédé comprend une étape, avant l'étape c), au cours de laquelle on réalise une étape de dopage par implantation ou par épitaxie en phase vapeur aux organométalliques, éventuellement avec différents dopages, sur les mésas d'In-GaN.

**11.** Substrat (30) comprenant successivement un support d'intérêt (31), une couche d'InGaN dopée (13) et poreuse, et une couche d'InGaN non intentionnellement dopée (14).

**12.** Substrat (30) selon la revendication 11, **caractérisé en ce que** le support d'intérêt (31) comprend une couche support (32), par exemple en saphir, en SiC ou en silicium, et une couche d'oxyde enterré (33).

**13.** Diode électroluminescente comprenant successivement : un substrat (30) et un empilement réépitaxié (40),
le substrat (30) comprenant :

- un support d'intérêt (31),
- une couche d'InGaN dopée et poreuse (13),
- une couche d'InGaN non intentionnellement dopée (14),

l'empilement réépitaxié (40) comprenant successivement depuis la couche d'InGaN non intentionnellement dopée (14) :

- une couche d'InGaN épitaxiée relaxée dopée d'un premier type de conductivité (41),
- une zone active (42) avec un ou plusieurs puits quantiques InGaN/(Ga,In)N émettant dans le rouge ou dans les vert,
- une couche d'InGaN dopée d'un second type de conductivité, différent du premier type de conductivité (44).

FIG.1A

FIG.1B

FIG.1C

FIG.1D

FIG.2A

FIG.2B

FIG.2C

FIG.2D

FIG.2E

FIG.3

EP 3 840 016 A1

FIG.4A

FIG.4B

FIG.4C

FIG.4D

FIG.4E

FIG.5

Europäisches
Patentamt

European
Patent Office

Office européen
des brevets

**RAPPORT DE RECHERCHE EUROPEENNE**

Numéro de la demande

EP 20 21 4254

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A,D | JANG LEE-WOON ET AL: "Electrical and structural properties of GaN films and GaN/InGaN light-emitting diodes grown on porous GaN templates fabricated by combined electrochemical and photoelectrochemical etching", JOURNAL OF ALLOYS AND COMPOUNDS, ELSEVIER SEQUOIA, LAUSANNE, CH, vol. 589, 11 décembre 2013 (2013-12-11), pages 507-512, XP028815812, ISSN: 0925-8388, DOI: 10.1016/J.JALLCOM.2013.12.034 * abrégé * * 2. Experimental; 3.3 Structural, electrical, MCL, and EL properties of the overgrown MQW LED films; 4. Conclusions * ----- | 1-13 | INV. H01L21/02 H01L21/306 H01L33/00 H01L33/12 H01L33/32 |
| A,D | EVEN A ET AL: "Enhanced In incorporation in full InGaN heterostructure grown on relaxed InGaN pseudo-substrate", APPLIED PHYSICS LETTERS, A I P PUBLISHING LLC, US, vol. 110, no. 26, 26 juin 2017 (2017-06-26), XP012219922, ISSN: 0003-6951, DOI: 10.1063/1.4989998 [extrait le 2017-06-26] * le document en entier * ----- | 1-13 | |
| A | US 2017/237234 A1 (HAN JUNG [US] ET AL) 17 août 2017 (2017-08-17) * alinéas [0051] - [0068]; figures 5A-5G * ----- | 1-13 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| La Haye | 14 avril 2021 | Szarowski, Anne |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

    .......................................................................

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 21 4254

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-04-2021

| Document brevet cité au rapport de recherche | Date de publication | Membre(s) de la famille de brevet(s) | Date de publication |
|---|---|---|---|
| US 2017237234 A1 | 17-08-2017 | CN 107078190 A | 18-08-2017 |
| | | EP 3201952 A1 | 09-08-2017 |
| | | JP 2018502436 A | 25-01-2018 |
| | | KR 20170063919 A | 08-06-2017 |
| | | US 2017237234 A1 | 17-08-2017 |
| | | WO 2016054232 A1 | 07-04-2016 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **EVEN et al.** Enhanced In incorporation in full InGaN heterostructure grown on relaxed InGaN pseudo-substrate. *Appl. Phys. Lett.,* 2017, vol. 110, 262103

- **JANG et al.** Electrical and structural properties of GaN films and GaN/InGaN light-emitting diodes grown on porous GaN templates fabricated by combined electrochemical and photoelectrochemical etching. *Journal of Alloys and Compounds,* 2014, vol. 589, 507-512